Europäisches Patentamt

European Patent Office

Office européen des brevets

(19)

(11) Publication number:     **0 200 732**
**B1**

(12)                    **EUROPEAN PATENT SPECIFICATION**

(45) Date of publication of patent specification: **20.09.89**

(21) Application number: **85900480.6**

(22) Date of filing: **19.12.84**

(86) International application number:
**PCT/GB84/00440**

(87) International publication number:
**WO 85/02870 04.07.85 Gazette 85/15**

(51) Int. Cl.⁴: **C 25 D 5/16,** C 25 D 5/10,
H 05 K 3/38

(54) **PRODUCTION OF A MATTE SURFACE OM A METAL LAYER.**

(30) Priority: **19.12.83 GB 8333752**

(43) Date of publication of application:
**12.11.86 Bulletin 86/46**

(45) Publication of the grant of the patent:
**20.09.89 Bulletin 89/38**

(84) Designated Contracting States:
**AT BE CH DE FR GB LI LU NL SE**

(56) References cited:
**WO-A-82/29911**
**US-A-3 918 926**

(73) Proprietor: **M & T LAMINATES LIMITED**
**William Street West Bromwich**
**West Midlands B70 0BE (GB)**

(72) Inventor: **THORPE, John, Edwin**
**46 Tenbury Crescent**
**North Shields Tyne & Wear NE29 9EP (GB)**
Inventor: **SARANG, Gursharan, Singh**
**150 Runnymede Road Darras Hall, Ponteland**
**Northumberland NE20 9HN (GB)**

(74) Representative: **Godwin, Edgar James et al**
**MARKS & CLERK 57-60 Lincoln's Inn Fields**
**London, WC2A 3LS (GB)**

## Description

### Technical field

This invention relates to a method of providing a metal layer with a matte surface. The method is of particular utility in the production of printed circuit boards for the electronics industry, but is of general utility for providing a matte metallic surface as an end product or as an intermediate product suitable for further treatment, e.g. for increasing the metallic surface area.

### Background art

To be able to bond copper to a dielectric base material so as to obtain the required peel strength characteristics it is necessary to provide a high surface area structure on the bonding face of the copper. In the production of conventional electrodeposited copper foil this high surface area is achieved by regulating the crystal growth by means of organic additives in the plating bath which, in combination with appropriate solution concentration and current density, provide a 'peak and valley' structure of controlled frequency onto which treatments can be applied; typical processes for achieving these results are disclosed in US patents 3674656 and 3918926. In the production of ultra thin foils (of the order of 5 μm) the total thickness of the end product is less than the typical peak and valley height of conventional foil so that to match the performance of such foils a novel approach must be adopted before comparable peel strengths can be achieved. The objective is to provide a high surface area crystal structure from a series of plating steps so that each layer of copper is firmly adherent to the layer onto which it is deposited but where the crystal structure is sufficiently 'open' at the surface to allow whichever adhesive system is used in the dielectric base material to penetrate the said structure and form a strong physical interlink between the two materials.

### Disclosure of invention

The present invention provides a method of providing a metal body or layer with a matte surface, comprising depositing on a first, smooth metal body or layer a second metal layer of dendritic form, and depositing on the second layer a third metal layer which is non-porous, fills the space between the dendrites of the second layer, has peaks which correspond to the peaks of the dendrites, and therefore has a matte surface.

The first layer may be constituted by the existing external metal surface of an existing article, such as a sheet or foil produced, for example, by electroforming or rolling (e.g. from nickel, copper-nickel alloy, brass, or copper), or may be carried by a temporary substrate which can subsequently be removed from the layered product, e.g. by mechanical separation or chemical dissolution. In the latter case the first layer, applied to the temporary substrate, need only be a very thin layer, e.g. 1 to 2 μm.

The deposition of the dendritic second layer can be controlled to provide a very dense peak and valley structure, i.e. the peaks are closely spaced, and the layer can be made very thin with uniform characteristics. The peaks formed by the dendrites serve as nucleation sites for the third layer so that the roughness of the denditic layer is reproduced in the exposed surface of the third layer. Because of this, the conditions under which the third layer is deposited can be easily controlled so that it is non-porous; in contrast, if a non-porous layer were deposited on a smooth surface, it would tend to have a smooth external surface as well.

The deposition of the third layer in accordance with the invention is not to be confused with the known methods of locking a powdery dendritic layer formed on a copper foil which is to be bonded to a dielectric base material; in such methods an extremely thin locking layer is applied whose purpose is to anchor the dendrites so that they cannot become detached and be encapsulated in the surface of the base material during lamination under pressure, when the base material flows into the interstices of the dendrites, i.e. the locking layer is a porous layer which is extremely thin so as not to clog the dendritic structure into which the base material is to flow during lamination. In contrast, the third layer of the present structure completely blocks off the dendritic second layer, whose purpose is simply to provide a rough substrate for the third layer.

The metals of the three layers may be the same or different. If the product is to be used in the production of printed circuit boards, the metal or metals chosen should be etchable by the etchant solutions commonly used in the industry, without causing contamination. The third layer can be subjected to known treatments to enhance its bonding to a dielectric base material; an improved method of treatment is described below.

### Brief description of drawings

The invention will be described further, by way of example, with reference to the accompanying drawings, in which:

Figures 1 to 4 are photomicrographs (magnification: 2000) of the surface of various electrodeposits on a polished substrate; and

Figure 5 is a schematic cross-section through copper layers deposited on a substrate by two different procedures.

### Best mode for carrying out the invention

The preferred method of deposition is by electrolysis, but other methods are feasible, the choice of deposition method being dependent on cost considerations and on the use to which the product is to be put. If the layers are deposited on a substrate, this can be in the form of a strip, the process being continuous.

The method of the invention is particularly applicable to the production of a press plate provided with a copper coil which can be transferred to a dielectric base material in a press. One of the major difficulties to be overcome in such a system is that the first layer of copper to be deposited onto the press plate must be deposited in such a way as to fulfill five important criteria:

i) Since it forms the outer surface of the finished laminate, it must be resistant to tarnishing and receptive to photoresists, solder, and plating-up procedures used in printed circuit board manufacture.

ii) It must release readily from the carrier plate after laminating but be sufficiently adherent to prevent premature detachment during processing.

iii) It must have a crystalline structure of sufficient density to prevent the resin bleeding through during the laminating process.

iv) It must be deposited in such a way as to provide total uniformity of thickness across the plated area.

v) This first 'strike' on the press plate must be receptive to the subsequent plating operations required to build up the matte structure of the treatment layers.

It has now been found that the above criteria can be satisfied if the first copper layer is applied to a polished press plate by electrodeposition from a copper pyrophosphate solution. The preferred solution contains 25 to 35 g/l of copper, 150 to 310 g/l of $P_2O_7$, 1 to 2 g/l of ammonia, and has a pH of 8 to 9. The resulting layer has a smooth surface and the method described above enables a 'core' layer having a matter surface to be formed on this, which is subjected to further treatment before lamination to prepreg (epoxy-resin-impregnated glass cloth). The preferred process will now be described by way of example only.

A second, very thin copper layer is plated onto the first layer from an acid copper bath in such a way that the layer is both dendritic and powdery. The level of 'roughness' achieved from this bath provides the underlying structure for the main copper core which will be plated next.

The third plating stage is carried out from a strong acid copper solution in such a way that the required thickness of copper is built up on the powdery dendritic layer by controlling the dwell time in the plating bath and the characteristics of the plating solution. Where the copper total thickness requirement is 5—9 µm a straightforward copper sulphate solution may be used. If the total thickness of the finished layer is 10—20 µm an organic additive may be introduced to control the grain size of the crystals deposited.

At the conclusion of this third stage a further microcrystalline (dendritic) layer of copper is deposited on the matte structure achieved in the preceding bath. This layer has a high surface area but is a relatively weak structure and following this fourth stage the plate is returned to a bath similar in strength to that used in stage three, where a further thin locking layer of copper (much thinner than the third layer) is deposited which conforms to and strengthens the underlying structures without substantially blocking their interstices. Finally, on this strengthened structure, a micro-crystallined powder deposit is plated in such a manner as to assist the wetting of the surface of the copper by the resin to be used in the laminating process. This six stage plating process is followed by a passivation stage which involves the immersion of the plate in a weak chromic acid solution to prevent any subsequent oxidation of the bonding surface.

The above process may be carried out by transporting the press plate through a plating line which contains the required number of baths. Equipment such as is required for the process is generally known in the art.

In the above-described manner an ultra thin layer of copper can be produced which has high purity, effective freedom from porosity, a peel strength which compares favourably with thicker foils, low unit cost in relation to competitive processes, reliability, and when separated from the press plate, a stain resistant outer surface which is compatible with all known printed circuit board manufacturing processes.

The mechanism which causes the copper to separate from the press plate at the conclusion of the laminating process has been determined as follows.

During laminating, the temperature and pressure in the laminating press are raised to cause the resin in the prepreg to revert to the liquid state and to penetrate the structure of the foil (up to the core layer). The efficiency of the separation is proportional to the degree to which resin penetrates the structure, because during cooling of the laminate before removal from the press the resin contracts and disturbs the copper/press plate interface so that the press plate lifts cleanly from the laminate for re-use. Experiments have shown that where there is little or no penetration of adhesive the separation is proportionally more difficult.

If the first strike of copper is carried out from a near neutral plating bath with high throwing power, and the metal carrier plate has the correct surface finish, the dense crystal structure of the first layer virtually guarantees that the foil as eventually plated will be free from pinholes or micro-porosity. In conventional foil making technology porosity on thin foils is a major problem because the copper foil is plated all from the same bath and, in the interests of economical production and so that a matte structure can be achieved, the bath used is an aqueous copper sulphate solution. Such baths, operated at the high current densities required to achieved economical levels of production, always pose difficulties in maintaining control of the nucleation sites of the copper at the start of the plating process. Micro-contamination of the drum surface or the solution can result in intercrystalline porosity which permits resin bleed through if such material is laminated. Rigorous testing is carried out by the foil producer and laminators so that the high standards required result in high scrap levels in the industry. The production of foil in a multi-stage sheet-by-sheet process as now proposed allows the copper core to be plated at high speed from a similar bath to that used in typical drum foil processes, but the nucleation site problem is avoided by plating this layer after a first strike. The near-neutral pyrophosphate bath also assists in obtaining an oxide free surface on the finished laminate.

Even if micro-pores are present in the copper plated on the press plate, resin bleed-through is effectively prevented because there is no space between the copper and the press plate into which the air entrapped in the micro-pores can escape, so that the resin cannot even enter the micro-pores.

Example

The preferred process will now be described in more detail, again by way of example only.

The press plate material most commonly used in the industry is of austenitic stainless steel. The function of such plates is to support and separate the laminates; since they are repeatedly subjected to compression in the laminating press, their hardness has to be such that their surface remains in good condition and that window framing (indentation by the laminated material, which is always smaller than the press plate) does not take place at such a rate as to interfere with the useful life of the plate. For the present process such stainless steel plates are perfectly satisfactory but so are titanium plates and chromium plated high tensile steel plates. In the end the choice of an ideal press plate material used in conjunction with the present process will devolve on factors that can readily be determined in a manufacturing environment. The process described below will work equally well on any of the three types of plate mentioned. What will change will be the frequency with which the plate surface is cleaned prior to plating.

Initially the plate (usually 1.5 to 3 mm thick) is polished by an abrasive brush, mop, or spray to provide a uniform finish of a surface roughness not exceeding 0.2 μm (preferably 0.1 μm) centre line average. After polishing, all traces of abrasive and products of abrasion are removed by washing and the plate retained in a clean condition before the plating cycle commences.

Plating for the process is carried out on one or both sides of the plate and in each case the plating cell is of a similar form. The cell consists of a rubber or plastics lined tank in which are disposed vertically two anodes equidistant and parallel to a pair of locating grooves incorporated into the tank wall. The locating grooves are used to establish the plate in the correct position relative to the anodes. The anode/cathode interspace is equipped with a splarge pipe when solution is introduced at a controlled rate depending on solution concentration and the current density applied to the anode. In the case of the first tank there is additionally a means of aerating the solution. The press plate is attached to a frame which conducts the negative d.c. current and ensures a uniform electrical distribution on the plate surface.

1st Plating step
Plating solution:

| | |
|---|---|
| Copper (as metal) | 30 g/l |
| Pyrophosphate as $P_2O_7$ | 180 g/l |
| Ammonia | 1 g/l |
| pH | 8.6—8.8 |
| Temperature | 50—55°C |
| Current density | 2.2—4.3 A/dm$^2$ |
| Anode-cathode gap | 7—12 cm |
| Anode material | copper. |

Potassium hydroxide is used to regulate the pH. The plating time depends on the current density and required thickness (generally 1—2 μm). During the plating process continuous aeration of the anode/cathode interspace is carried out to prevent the copper deposit from 'burning'.

The pH of the bath is regulated continuously to maintain it in the range 8.6—8.8. Variations on either side of these levels may result in copper which adheres too strongly to the press plate or is porous or both.

Other bath conditions as specified above are very important in producing a fine crystal structure with the correct level of adhesion. This bath when in operation is continuously circulated through a holding tank by means of a pumped system wherein it is filtered and purified by activated-carbon treatment before being introduced into the plating cell.

The copper deposit resulting from this bath should exhibit a clean, smooth pink appearance and it should be possible to peel the deposit from the plate. After washing, the plate is transferred to the next plating tank.

2nd Plating step
The bath conditions are as follows:

| | |
|---|---|
| Copper (as metal) | 25—30 g/l |
| Sulphuric acid | 60—120 g/l |
| Arsenic | 300—400 mg/l |
| Anode material | lead |
| Anode-cathode gap | 3.5—5 cm |
| Current density | 16—27 A/dm$^2$ |
| Temperature | ambient |
| Plating time | 6—9 s. |

The solution is also circulated through a holding tank and filtration system and its freedom from organic and inorganic contamination is vital to its performance.

When removed from this bath the first copper layer should have been covered by a uniformly brown coloured powdery dendritic deposit which is a mixture of copper and copper oxide of high surface area. The plate can be transferred without intermediate washing to the next plating process.

## 3rd Plating step

The bath conditions are as follows:

| | |
|---|---|
| Copper (as metal) | 70—90 g/l |
| Sulphuric acid | 90—120 g/l |
| Anode material | lead |
| Anode-cathode gap | 3.5—5 cm |
| Current density | 22—43 A/dm². |

The plating time depends on the thickness of copper required. Also depending on the final thickness of copper to be plated an organic grain-modifying agent may be required to be added continuously to the solution. For this purpose a 2 g/l solution of an appropriate animal glue can be introduced at the rate of 35—65 ml/min, depending on the solution circulation rate through the cell and the current density being used. Solution circulation through the tank would be 50—60 l/minute and the solution is again filtered and carbon treated.

From this bath a third copper layer is built up which follows the contours of only the peaks of the dendrites of the underlying 'brown' second layer. This induces a crystal growth which results in a matte non-porous structure particularly appropriate for copper layers which will ultimately be bonded to dielectric base materials. The copper from this bath forms the core of the copper foil and can be anything from 3—20 microns thick.

The product is now transferred without washing to the fourth plating bath.

## 4th Plating step

The bath conditions are as follows:

| | |
|---|---|
| Copper (as metal) | 18—22 g/l |
| Sulphuric acid | 60—100 g/l |
| Anode material | lead |
| Anode-cathode gap | 3.5—5 cm |
| Current density | 16—27 A/dm² |
| Plating time | 5—9 s |
| Solution circulation | 25—40 l/min. |

Solution continuously filtered and activated-carbon treated. This bath provides a very thin layer of dendrites on the matte structure produced in the third bath, which gives a substantial increase in total surface area. These dendrites are weakly adherent to the matte surface and are locked in position by the following plating step described below.

## 5th Plating step

The bath conditions are as in the third step except that the plating time is only 3—10 seconds, i.e. much shorter. The copper deposited forms a locking layer which anchors the dendrites without filling up the interstices between the dendrites, into which the resin is to penetrate.

After this locking layer of copper has been applied, a final very thin layer of copper/copper oxide is deposited from a weak copper sulphate solution, as follows.

## 6th Plating step

The bath conditions are as follows:

| | |
|---|---|
| Copper (as metal) | 4.5—7.5 g/l |
| Sulphuric acid | 30—60 g/l |
| Anode material | lead |
| Anode-cathode gap | 3.5—5 cm |
| Temperature | 18—21°C |
| Current density | 2.2—6.5 A/dm² |
| Plating time | 5—20 s. |

Solution continuously filtered and activated-carbon treated. The micro-crystalline deposit from this bath is of copper/copper oxide and has excellent wetting properties with certain resins used in the production of dielectric base materials. Its effect is to promote the penetration of the resins to the matte structure to provide a strong bond between the two materials.

After this final plating process, the copper deposit is thoroughly washed by a fine spray of hot water (60°C) before passing to a passivating bath which prevents the copper layer oxidising. This bath contains 1 g/l $CrO_3$ and is operated at 50°C. The plate is immersed in this solution for 5—10 seconds before a final wash with a hot water spray and hot air drying.

The so-called caul plate is now ready for laminating and the surface must be protected from accidental damage until it is placed in the laminating press.

5 µm thick copper produced on a press plate in the manner described above was pressed on prepreg in a laminating press along with control samples of 20 µm copper foil available as an article of commerce. The prepreg was made utilising a high molecular weight rein system typically used for high resistance laminates where thin foils are commonly employed.

After laminating the samples were removed from the press and the copper layer was found to have been transferred from the press plate to the base, leaving the press plate free of all traces of copper and in a condition where it could immediately have been passed through the plating process once again.

The copper clad laminates produced according to the process described above are remarkably clean and free from oxidation. This is because all trace of air is excluded from the press plate/copper interface during the laminating process, whereas in laminating conventional foil the unavoidable presence of air causes a bloom to occur on the copper shiny side due to the elevated temperature of the pressing cycle. This bloom can interfere with subsequent processing and frequently requires trimming off edges or physical abrasion of the copper to remove it.

The samples referred to above were tested for peel strength as follows. The 5 µm clad laminate was placed into a copper sulphate plating bath and plated up until its thickness was equivalent to the 20 µm sample of conventional foil. Both samples were then coated with a photoresist so that they could be etched in such a way as to leave copper tracks 3 mm wide on the base laminate. These tracks were then peeled back vertically from the laminate and the force required to strip the copper was measured. In the case of the conventional 20 μm foil the force required was 11 N/cm and in the case of the 5 μm plated to 20 μm the force required was 12 N/cm. These tests were repeated on numerous occasions and the 5 micron clad material reliably outperformed the standard 20 μm material on the dielectric base material used. Such peel strength performance is unprecedented in such thin foil laminates. Furthermore, the copper is of high quality in terms of surface finish and freedom from porosity.

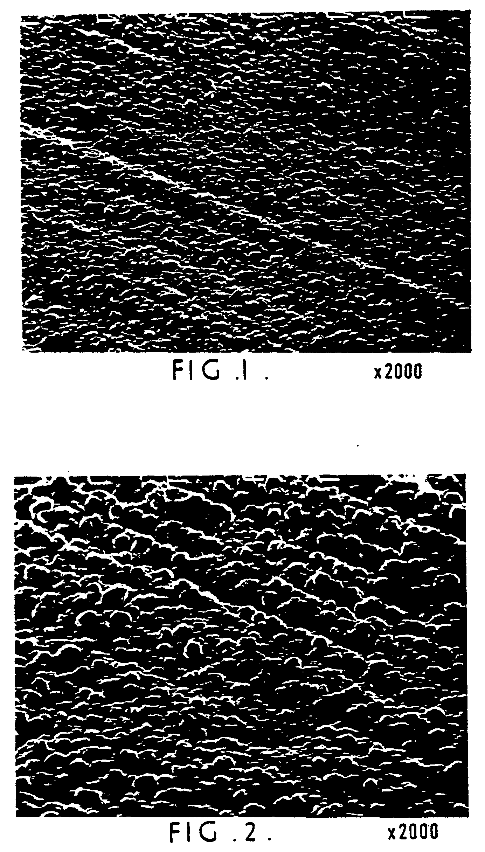

The improvement brought about by the inclusion of the dendritic second layer is illustrated by the photomicrographs of Figures 1 to 4, in which the magnification is 2000.

Figure 1 shows the surface of a 5 μm copper foil deposited on a polished stainless steel caul plate in two stages, viz. deposition from a copper pyrophosphate solution (to 1—2 μm) followed by deposition from a strongly acid copper sulphate solution (to 5 μm). It can be seen that the resulting surface is relatively smooth, reproducing the smoothness of the polished surface of the caul plate (including a scratch running obliquely from top left to bottom right).

In contrast, Figure 2 shows the surface of a 5 μm copper foil deposited on a stainless steel caul plate in three stages in accordance with the present invention, viz, deposition from a copper pyrophosphate solution (to 1—2 μm), next deposition of a dendritic second layer (about 1 μm thick or less) from strongly acid copper sulphate solution doped with arsenic, and finally deposition from strongly acid copper sulphate solution (as before, to 5 μm). It can be seen that a very rough matte surface has been achieved, in which the peaks of the underlying dendritic layer are clearly reproduced.

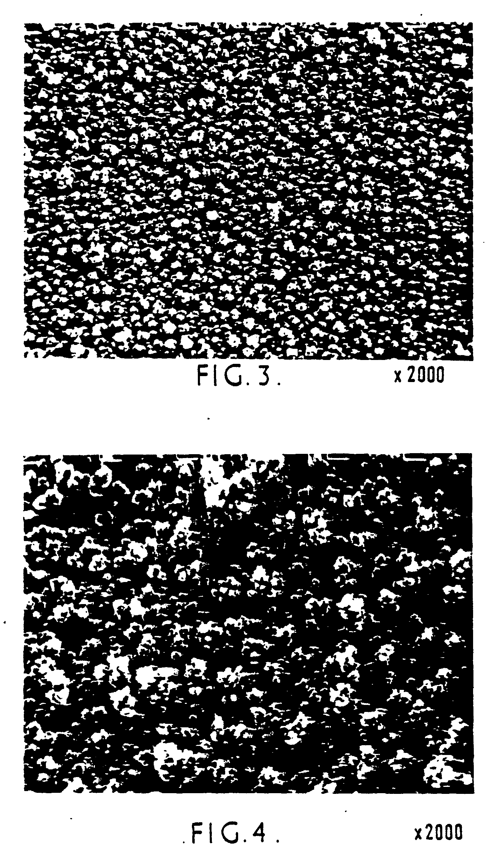

Figures 3 and 4 show the effect of subjecting the surfaces of Figures 1 and 2 (respectively) to the 4th to 6th plating steps described above. Figure 3 reveals a surface made up of small, closely packed dendrites which provide very poor bonding to resin. In contrast, Figure 4 clearly shows complex dendrites with interstices which are easily penetrated by resin and which provide excellent bonding.

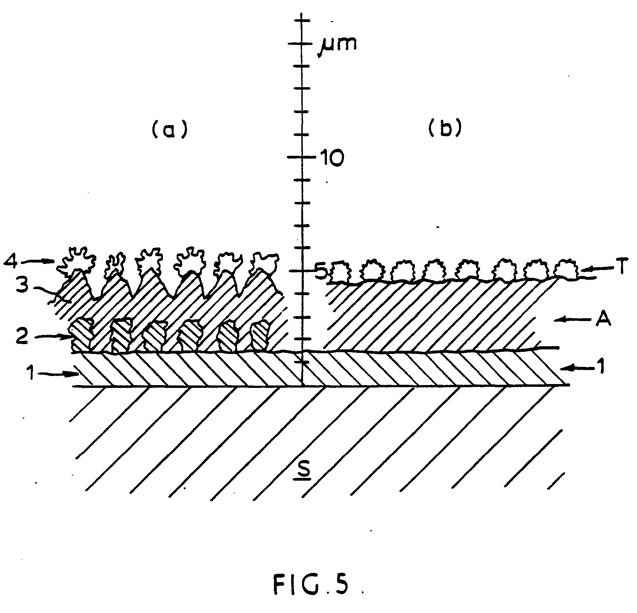

Figure 5 shows schematic cross-sections (a) and (b) through the layers of Figures 4 and 3 respectively. The scale indicates the thickness of copper in μm above the surface of the stainless steel substrate S. In each case a copper layer 1 is deposited from a pyrophosphate solution. In section (a) a dendritic second-layer 2 consisting of uniform elongate copper nodules is then deposited, followed by an acid copper layer 3 having peaks corresponding to the nodules. The subsequent treatment, as described above, produces dendrites 4 on the peaks of the layer 3. In contrast, in section (b) the acid copper layer A is deposited directly on the smooth pyrophosphate copper, layer 1 and, as a result, has no peaks;

consequently, the final dendritic treatment layer T is a much less effective bonding structure.

**Claims**

1. A method of providing a metal body or layer with a matte surface, comprising depositing on a first, smooth metal body or layer a second metal layer of dendritic form, and depositing on the second layer a third metal layer which is nonporous, fills the space between the dendrites of the second layer, has peaks which correspond to the peaks of the dendrites, and therefore has a matte surface.

2. A method as claimed in claim 1, in which the first layer has been deposited on a smooth substrate.

3. A method as claimed in claim 2, in which the first layer is 1 to 2 μm thick.

4. A method as claimed in claim 2, in which the first layer is a copper layer and is electrodeposited from a copper pyrophosphate solution.

5. A method as claimed in claim 1, in which the third layer is at least 2 μm thick.

6. A method as claimed in claim 1, further comprising depositing on the third layer a fourth metal layer of dendritic form.

7. An article having a matte surface, comprising a first, smooth metal body or layer; a superposed second metal layer of dendritic form; and a superposed third metal layer which is non-porous, fills the spaces between the dendrites of the second layer, has peaks which correspond to the peaks of the dendrites, and therefore has a matte surface.

8. An article as claimed in claim 7, further comprising a smooth substrate supporting the first layer.

9. An article as claimed in claim 7, further comprising a fourth metal layer of dendritic form superposed on the third layer.

10. An article as claimed in claim 7, in which the total thickness of the first, second, and third layer is less than 10 μm.

11. A method of preparing a copper foil for bonding to a dielectric base material, comprising

(a) forming a first, smooth copper layer on a polished metal substrate by electrodeposition from a copper pyrophosphate solution;

(b) depositing on the first layer a thin second copper layer of dendritic form;

(c) depositing on the second layer from a strong acid copper solution a non-porous third copper layer which fills the spaces between the dendrites of the second layer and has peaks which correspond to the peaks of the dendrites;

(d) depositing, on the peaks of the third layer, a fourth layer consisting of copper dendrites;

(e) depositing on the fourth layer a thin fifth copper layer which substantially follows the contours of the fourth layer; and

(f) depositing a micro-crystalline deposit on the fifth layer.

## Patentansprüche

1. Verfahren zum Ausstatten eines metallischen Körpers oder einer metallischen Schicht mit einer matten Oberfläche, umfassend: Abscheiden auf einem ersten glatten Metallkörper oder einer ebensolchen Schicht, einer zweiten Metallschicht dendritischer Form; und Abscheiden auf der zweiten Schicht einer dritten Metallschicht, die nichtporös ist, den Raum zwischen den Dendriten der zweiten Schicht füllt und über Peaks oder Spitzen verfügt, die den Spitzen der Dendriten entsprechen und somit über eine matte Oberfläche verfügt.

2. Verfahren nach Anspruch 1, bei dem die erste Schicht auf einem glatten Substrat abgeschieden wurde.

3. Verfahren nach Anspruch 2, bei dem die erste Schicht 1 bis 2 µm dick ist.

4. Verfahren nach Anspruch 2, bei dem die erste Schicht eine Kupferschicht ist und aus einer Kupferpyrophosphatlösung galvanisch abgeschieden wird.

5. Verfahren nach Anspruch 1, bei dem die dritte Schicht wenigstens 2 µm dick ist.

6. Verfahren nach Anspruch 1, weiterhin umfassend: Abscheiden auf der dritten Schicht einer vierten Metallschicht von dendritischer Form.

7. Artikel mit einer matten Oberfläche umfassend: einen ersten glatten Metallkörper oder eine ebensolche Schicht; eine überlagerte zweite Metallschicht dendritischer Form; und eine überlagerte dritte Metallschicht die nicht porös ist, die Räume zwischen den Dendriten der zweiten Schicht füllt, Spitzen oder Peaks hat, die den Peaks der Dendriten entsprechen und somit über eine matte Oberfläche verfügt.

8. Artikel nach Anspruch 7, weiter umfassend: ein glattes, die erste Schicht tragendes Substrat.

9. Artikel nach Anspruch 7, weiter umfassend: eine vierte Metallschicht dendritischer Form, die auf der dritten Schicht überlagernd ausgebildet ist.

10. Artikel nach Anspruch 7, bei dem die gesamte Dicke der ersten, zweiten und dritten Schicht geringer als 10 µm ist.

11. Verfahren zum Herstellen einer Kupferfolie zur Bindung an oder zum Verbinden mit einem dielektrischen Basis- oder Grundmaterial, umfassend:

(a) Bilden einer ersten glatten Kupferschicht auf einem polierten Metallsubstrat durch galvanische Abscheidung aus einer Kupferpyrophosphatlösung;

(b) Abscheiden aus des ersten Schicht einer dünnen zweiten Kupferschicht dendritischer Form;

(c) Abscheiden auf der zweiten Schicht, aus einer stark sauren Kupferlösung, eine nicht-poröse dritte Kupferschicht, welche die Räume zwischen den Dendriten der zweiten Schicht füllt und Peaks oder Spitzen aufweist, die den Peaks der Dendriten entsprechen;

(d) Abscheiden auf den Peaks oder Spitzen der dritten Schicht einer vierten aus Kupferdendriten bestehenden Schicht;

(e) Abscheiden auf der vierten Schicht einer fünften Kupferschicht, die im wesentlichen den Konturen der vierten Schicht folgt; und

(f) Abscheiden einer mikrokristallinen Abscheidung auf der fünften Schicht.

## Revendications

1. Procédé de production d'un corps ou d'une couche métalliques ayant une surface mate, comprenant le dépôt sur un premier corps ou une première couche métalliques lisses d'une seconde couche métallique de forme dendritique et le dépôt sur la seconde couche d'une troisième couche métallique qui est non-poreuse, comble l'espace entre les dendrites de la seconde couche, possède des pics correspondant aux pics des dendrites, et par conséquent présente une surface mate.

2. Procédé selon la revendication 1, dans lequel on dépose une première couche par électrolyse.

3. Procédé selon la revendication 2 dans lequel la première couche a une épaisseur de 1 à 2 µm.

4. Procédé selon la revendication 2 dans lequel la première couche est une couche de cuivre déposée par électrolyse à partir d'une solution de pyrophosphate de cuivre.

5. Procédé selon la revendication 1 dans lequel la troisième couche a une épaisseur d'au moins 2 µm.

6. Procédé selon la revendication 1, comprenant en outre le dépôt d'une quatrième couche métallique de forme dendritique sur la troisième couche.

7. Article ayant une surface mate, comprenant un premier corps ou une première couche lisses surmontés d'une seconde couche métallique, de forme dendritique surmontée d'une troisième couche métallique laquelle est non-poreuse, comble les espaces entre les dendrites de la seconde couche, possède des pics correspondant aux pics des dendrites, et par conséquent présente une surface mate.

8. Article selon la revendication 7, comprenant en outre un substrat lisse servant de support à la première couche.

9. Article selon la revendication 7, comprenant en outre une quatrième couche métallique de forme dendritiqué déposée sur la troisième couche.

10. Article selon la revendication 7, dans lequel l'épaisseur totale des première, seconde et troisième couches est inférieure à 10 µm.

11. Procédé de préparation d'un feuil de cuivre destiné à être lié à un matériau de base diélectrique dans lequel:

a) on forme une première couche de cuivre lisse sur un substrat métallique poli, par électrodéposition à partir d'une solution de pyrophosphate de cuivre;

b) on dépose une fine seconde couche de cuivre de forme dendritique sur la première couche;

c) on dépose une troisième couche de cuivre non-poreuse sur la second couche à partir d'une solution fortement acide de cuivre, laquelle troisième couche comble les espaces entre les dendrites de la seconde couche et possède des pics correspondant aux pics des dendrites;

d) on dépose, sur les pics de la troisième couche une quatrième couche consistant en dendrites de cuivre;

e) on dépose sur la quatrième couche une fine cinquième couche de cuivre qui épouse substantiellement les contours de la quatrième couche; et

f) on réalise un dépôt micro-cristallin sur la cinquième couche.

FIG .1 .                    x2000

FIG .2 .                    x2000

1

FIG. 3.    x 2000

FIG. 4.    x 2000

FIG.5